# EUROPÄISCHE PATENTANMELDUNG

(11) **EP 1 842 838 A2**
(43) Veröffentlichungstag der Anmeldung: **10.10.2007**
(21) Anmeldenummer: 07103720.4
(22) Anmeldetag: 07.03.2007
(51) Int. Cl.: C04B 35/58, C04B 35/628

(54) **Pulvermaterialien für die MGB2-Supraleiterherstellung und Verfahren zur Herstellung dieser Pulver materialien**

(30) Priorität: 07.04.2006 DE 102006017435
(71) Anmelder: Leibniz-Institut für Festkörper- und Werkstoffforschung E.V., 01069 Dresden (DE)
(72) Erfinder: Hässler, Wolfgang, 01169 Dresden (DE); Eibl, Oliver, 72138 Kirchentellinsfurt (DE); Herrmann, Mirko, 01159 Dresden (DE)
(74) Vertreter: Rauschenbach, Marion

(57) **Zusammenfassung**

Pulvermaterialien für die MgB₂-Supraleiterherstellung und Verfahren zur Herstellung dieser Pulvermaterialien

Die Erfindung bezieht sich auf das Gebiet der Physik und betrifft Pulvermaterialien, die beispielsweise für die Herstellung von MgB₂-Supraleiterdrähten oder -bändern zur Anwendung in der Energietechnik eingesetzt werden können.

Die Aufgabe der Erfindung besteht in der Angabe von Pulvermaterialien, die zu MgB₂-Supraleitern mit einer verbesserten kritischen Stromdichte in Abhängigkeit des Magnetfeldes führen.

Gelöst wird die Aufgabe durch Pulvermaterialien mindestens bestehend aus Pulverteilchen mit einem Kern aus Mg und B und/oder aus ganz oder teilweise umgesetzten MgB₂ und/oder aus Precursoren für Mg-, B- und/oder MgB₂-Pulver, und aus mindestens einer um den Kern angeordneten ein- oder mehrphasigen Schale.

Die Aufgabe wird weiterhin gelöst durch ein Verfahren, bei dem den Ausgangspulvern zum Aufbau einer ein- oder mehrphasigen Schalenstruktur Beimengungen in Form eines Pulvers oder aus der Gasphase oder aus der Flüssigphase vor oder während der Reaktion zu MgB₂-Supraleitern zugegeben werden.

## Beschreibung

Die Erfindung bezieht sich auf das Gebiet der Physik und der Materialwissenschaften und betrifft Pulvermaterialien für die MgB₂-Supraleiterherstellung, die beispielsweise für die Herstellung von MgB₂-Supraleiterdrähten oder -bändern zur Anwendung in der Energietechnik eingesetzt werden können und Verfahren zur Herstellung dieser Pulvermaterialien.

Supraleitung mit Sprungtemperaturen von 38 bis 40 K in der binären Legierung MgB₂ wurde erstmals 2001 nachgewiesen (J. Nagamatsu, u.a., Nature 410 (2001), 63). Derartige Supraleiter sind daher in der Lage, metallische Supraleiter mit deutlich niedrigeren Sprungtemperaturen in ihrer Anwendung zu ersetzen. Dazu ist es aber notwendig, dass die MgB₂-Supraleiter die anderen positiven Eigenschaften der metallischen Supraleiter mindestens gleichwertig erfüllen. Dies betrifft insbesondere die kritische Stromdichte. Diese muss für MgB₂-Supraleiter in Abhängigkeit vom Magnetfeld deutlich gesteigert werden.

Eine Möglichkeit zur Steigerung der kritischen Stromdichten von MgB₂-Supraleitern ist der Einbau von Si und/oder C, als Elemente oder Verbindungen (WO 03/106373 A1). Es wird davon ausgegangen, dass diese Zugaben in der Mikrostruktur des MgB₂ als Störungen eingebaut werden, die auf der Skala der supraleitenden Kohärenzlänge liegen und in der Lage sind, magnetische Flussschläuche festzuhalten (Flusslinienpinning-Zentren). Mit diesen Zugaben wird eine Verbesserung der kritischen Stromdichten in Abhängigkeit von Magnetfeld von einer 10-er Potenz erreicht.

Hergestellt werden MgB₂-Supraleiter beispielsweise durch die Wärmebehandlung eines Bor-Drahtes in Anwesenheit eines Mg-Pulvers (Canfield et al., Cond. Mat. publ. Cond-mat Homepage vom 15.02.2001: cond-mat/0102289). Dieses Herstellungsverfahren ist aber für die industrielle Anwendung wenig geeignet.

Weiterhin bekannt sind Verfahren zur Herstellung von supraleitenden Drähten und Bändern mittels Pulver-in-Rohr-Technologie, bei der ein Hüllrohr aus normalleitendem Material mit einem darin enthaltenden Pulver aus einer Supraleiterverbindung oder den Vorprodukten einer Supraleiterverbindung durch Umformungs- und Wärmebehandlungsschritte zu einem supraleitenden Draht oder Band verarbeitet wird (DE 102 11 538 A1).

Die Aufgabe der Erfindung besteht in der Angabe von Pulvermaterialien für die MgB₂-Supraleiterherstellung, die zu MgB₂-Supraleitern mit einer verbesserten kritischen Stromdichte in Abhängigkeit des Magnetfeldes führen und in der Angabe eines einfachen Verfahrens zur Herstellung dieser Pulvermaterialien.

Die Aufgabe wird durch die in den Ansprüchen angegebene Erfindung gelöst. Vorteilhafte Ausgestaltungen sind Gegenstand der Unteransprüche.

Die erfindungsgemäßen Pulvermaterialien für die MgB₂-Supraleiterherstellung bestehen mindestens aus Pulverteilchen mit einem Kern aus Mg und B und/oder aus ganz oder teilweise umgesetzten MgB₂ und/oder aus Precursoren für Mg-, B- und/oder MgB₂-Pulver, und aus mindestens einer um den Kern angeordneten Schale, die ein- oder mehrphasig ist.

Vorteilhafterweise sind weitere nano-skalige Pulverteilchen vorhanden, die aus nichtsupraleitenden Pulvermaterialien oder Phasen bestehen und/oder nach der Herstellung zu MgB₂-Supraleiter nichtsupraleitende Pulvermaterialien oder Phasen bilden.

Ebenfalls vorteilhafterweise besteht der Kern der Pulverteilchen aus Mg und B und MgB₂.

Weiterhin vorteilhafterweise besteht die Schale aus einem ein- oder mehrphasigen Pulvermaterial, welches Mg und/oder B und/oder MgB₂ enthält.

Von Vorteil ist es, wenn die Schale aus einem ein- oder mehrphasigen Pulvermaterial besteht, welches kein Mg und/oder B und/oder MgB₂ enthält.

Auch von Vorteil ist es, wenn die Schale aus einer oxidischen und/oder nitridischen und/oder carbidischen Phase besteht, wobei noch vorteilhafterweise die Schale Oxide und/oder Nitride und/oder Carbide des Mg, B, Si oder MgO, BO, BN, SiC, Si₃N₄ und/oder Mg₁₋ₓOₓB_{(2-y)}O_{y} mit x = >0 bis 0,5 und y= >0 bis 1 enthält.

Und auch von Vorteil ist es, wenn mindestens 50 Vol.-% des Supraleiterpulvers aus Teilchen mit einem Kern-Schale-Aufbau bestehen.

Vorteilhaft ist es auch, wenn die Pulverteilchen einen durchschnittlichen Teilchendurchmesser von ≤ 2 µm aufweisen, wobei die Dicke der Schale ≤ 200 nm, vorteilhafterweise einen durchschnittlichen Teilchendurchmesser von ≤ 1 µm aufweisen, wobei die Dicke der Schale ≤ 100 nm beträgt, und noch vorteilhafterweise einen durchschnittlichen Teilchendurchmesser von ≤ 0,5 µm aufweisen, wobei die Dicke der Schale ≤100 nm beträgt.

Bei dem erfindungsgemäßen Verfahren zur Herstellung von Pulvermaterialien für die MgB₂-Supraleiterherstellung werden den Ausgangspulvern, die mindestens aus Mg und B und/oder aus ganz oder teilweise umgesetzten MgB₂-Pulvern und/oder aus Precursoren für Mg-, B- und/oder MgB₂-Pulver bestehen, zum Aufbau einer ein- oder mehrphasigen Schalenstruktur Beimengungen in Form eines Pulvers oder aus der Gasphase oder aus der Flüssigphase vor oder während der Reaktion zu MgB₂-Supraleitern zugegeben.

Vorteilhafterweise werden die Beimengungen vor der Reaktion zu MgB₂-Supraleitern bei höheren Temperaturen, vorteilhafterweise bei Temperaturen bis 900 °C zugegeben.

Weiterhin von Vorteil ist es, wenn als Beimengungen Sauerstoff und/oder Stickstoff und/oder Kohlenstoff zugegeben werden.

Von Vorteil ist es auch, wenn die Reaktion zu MgB₂-Supraleitern in einer sauerstoffhaltigen oder stickstoffhaltigen oder kohlenstoffhaltigen Atmosphäre realisiert wird, wobei die Reaktion zu MgB₂-Supraleitern in einer Atmosphäre mit einem Sauerstoffgehalt oder Stickstoffgehalt oder Kohlenstoffgehalt von 0,1 bis 10 Vol.-% durchgeführt wird, wobei die Reaktionstemperatur 900 °C nicht überschreitet.

Ebenfalls von Vorteil ist es, wenn die Beimengungen in der Flüssigphase unter höheren Temperaturen bis über den Schmelzpunkt der Beimengungen zugegeben werden.

Durch die erfindungsgemäße Lösung sind Pulvermaterialien für die MgB₂-Supraleiterherstellung herstellbar, die aufgrund ihres Kern-Schale-Aufbaus und der Struktur und dem Aufbau der Schale als Flusslinienpinning-Zentren wirken.

Vorteilhafterweise können noch weitere Pulvermaterialien in das Pulver eingebracht werden, die als zusätzliche Flusslinienpinning-Zentren wirken. Solche zusätzlichen Pulvermaterialien lassen sich nach dem Stand der Technik, d.h. durch Vermischen des MgB₂-Pulvers mit einem nano-skaligen Zusatzpulver, schwer homogen in die Pulvermischung einbringen. Die Pulvermischungen liegen wegen der Agglomeratbildung von nanokristallinem Pulver auch oft nicht in der richtigen Größe vor.

Im Gegensatz dazu führen die erfindungsgemäßen homogener aufgebauten Pulverteilchen mit Kern-Schale-Struktur, die mit dem einfacheren erfindungsgemäßen Herstellverfahren realisiert werden, zu einer homogenen Verteilung der Zusatzstoffe innerhalb des Pulvers. Nach der vollständigen Reaktion zu MgB₂, liefern so hergestellte Drähte eine deutlich meßbare Stromdichteerhöhung in einem weiten Magnetfeldbereich .gegenüber solchen Leitern, die mit den gleichen Ausgangspulvern, jedoch ohne Kern-Schale-Struktur hergestellt wurden.

Die erfindungsgemäße Kern-Schale-Struktur der Pulverteilchen ist dabei nicht im streng geometrischen Sinne zu verstehen. Als Schale soll im Rahmen dieser Erfindung der phasenartig andere Aufbau um einen Kern verstanden werden, der sowohl volumenmäßig als auch hinsichtlich seiner Phasenzusammensetzung nicht vollständig und nicht homogen ausgebildet sein muss. Dabei kann der Schalenaufbau unterschiedliche Phasen sowohl als ebenfalls schalenförmig angeordnet oder auch in nur bestimmten Bereichen der Schale angeordnet aufweisen.

Nachfolgend wird die Erfindung an einem Ausführungsbeispiel näher erläutert.

### Beispiel 1

Die generelle Herstellung eines erfindungsgemäßen Pulvermaterials erfolgt, indem die Ausgangspulver zunächst eingewogen und gemahlen werden, wobei die bekannten Mahltechniken zum Einsatz kommen. Dann wird in der Pulvermischung mittels Beimengungen aus der Gas- oder Flüssigphase oder aber durch feste Pulvermaterialien eine Kern-Schale-Struktur der Pulverteilchen aufgebaut.

Ausgehend von einem Mg-Pulver wird durch Zuführung von Sauerstoff bei erhöhten Temperaturen das Mg über die Gasphase oxidiert, so dass die Mg-Pulverteilchen einen Mg-Kern und eine dünne Schale aus MgO aufweisen. Sauerstoff wird über ein regelbares Ventil dosiert in den Probenraum eingelassen und damit eine oberflächliche Oxidation der Mg-Pulverteilchen erreicht. Danach werden die Pulver nochmals gemahlen.

Nachfolgend werden die Pulver mit überwiegend Pulverteilchen mit Kern-Schale-Struktur mittels der bekannten Pulver-im-Rohr-Technologie zu supraleitenden Drähten weiterverarbeitet. In diesem Prozess werden Umformtechniken zum Einsatz gebracht, die Zwischenglühungen enthalten, bei denen die Hüllrohre weich geglüht werden. Der vollständige Umsatz zur supraleitenden Phase erfolgt bei einer Glühung zwischen 400°C und 900°C, wobei bei Pulverteilchen mit geringen Durchmessern niedrigere Temperaturen und bei solchen mit größeren Durchmessern höhere Temperaturen anzuwenden sind. Die Glühung erfolgt in Ar-Atmosphäre.

Auf diese Weise hergestellte Drähte zeigen über einen weiten Magnetfeldbereich 10-fach höhere kritische Stromdichten von > 5x10⁵ A/cm² bei 2T und 20K als Drähte, die mit den gleichen Pulverteilchen, aber ohne Kern-Schale-Struktur hergestellt wurden.

Untersuchungen der Mikrostruktur zeigen, dass die Supraleiter homogen verteilte sauerstoffreiche Ausscheidungen enthalten, deren Durchmesser ungefähr 20 nm betragen, d.h. nahe an der supraleitenden Kohärenzlänge von MgB₂ liegen.

## Patentansprüche

1. Pulvermaterialien für die MgB₂-Supraleiterherstellung mindestens bestehend aus Pulverteilchen mit einem Kern aus Mg und B und/oder aus ganz oder teilweise umgesetzten MgB₂ und/oder aus Precursoren für Mg-, B- und/oder MgB₂-Pulver, und aus mindestens einer um den Kern angeordneten Schale, die ein- oder mehrphasig ist.

2. Pulvermaterialien nach Anspruch 1, bei denen weitere nano-skalige Pulverteilchen vorhanden sind, die aus nichtsupraleitenden Pulvermaterialien oder Phasen bestehen und/oder nach der Herstellung zu MgB₂-Supraleiter nichtsupraleitende Pulvermaterialien oder Phasen bilden.

3. Pulvermaterialien nach Anspruch 1, bei denen der Kern der Pulverteilchen aus Mg und B und MgB₂ besteht.

4. Pulvermaterialien nach Anspruch 1, bei denen die Schale aus einem ein- oder mehrphasigen Pulvermaterial besteht, welches Mg und/oder B und/oder MgB₂ enthält.

5. Pulvermaterialien nach Anspruch 1, bei denen die Schale aus einem ein- oder mehrphasigen Pulvermaterial besteht, welches kein Mg und/oder B und/oder MgB₂ enthält.

6. Pulvermaterialien nach Anspruch 1, bei denen die Schale aus einer oxidischen und/oder nitridischen und/oder carbidischen Phase besteht.

7. Pulvermaterialien nach Anspruch 6, bei denen die Schale Oxide und/oder Nitride und/oder Carbide des Mg, B, Si enthält.

8. Pulvermaterialien nach Anspruch 6, bei denen die Schale MgO, BO, BN, SiC, Si₃N₄ und/oder Mg₁₋ₓOₓB_{(2-y)}O_{y} mit x = >0 bis 0,5 und y= >0 bis 1 enthält.

9. Pulvermaterialien nach Anspruch 1, bei denen mindestens 50 Vol.-% des Supraleiterpulvers aus Teilchen mit einem Kern-Schale-Aufbau bestehen.

10. Pulvermaterialien nach Anspruch 1, bei denen die Pulverteilchen einen durchschnittlichen Teilchendurchmesser von ≤ 2 µm aufweisen, wobei die Dicke der Schale ≤ 200 nm beträgt.

11. Pulvermaterialien nach Anspruch 10, bei denen die Pulverteilchen einen durchschnittlichen Teilchendurchmesser von ≤ 1 µm aufweisen, wobei die Dicke der Schale ≤ 100 nm beträgt.

12. Pulvermaterialien nach Anspruch 10, bei denen die Pulverteilchen einen durchschnittlichen Teilchendurchmesser von ≤ 0,5 µm aufweisen, wobei die Dicke der Schale ≤ 100 nm beträgt.

13. Verfahren zur Herstellung von Pulvermaterialien für die MgB₂-Supraleiterherstellung nach mindestens einem der Ansprüche 1 bis 12, bei dem den Ausgangspulvern mindestens aus Mg und B und/oder aus ganz oder teilweise umgesetzten MgB₂-Pulvern und/oder aus Precursoren für Mg-, B- und/oder MgB₂-Pulver zum Aufbau einer ein- oder mehrphasigen Schalenstruktur Beimengungen in Form eines Pulvers oder aus der Gasphase oder aus der Flüssigphase vor oder während der Reaktion zu MgB₂-Supraleitern zugegeben werden.

14. Verfahren nach Anspruch 13, bei dem die Beimengungen vor der Reaktion zu MgB₂-Supraleitern bei höheren Temperaturen zugegeben werden.

15. Verfahren nach Anspruch 14, bei dem die Zugabe bei Temperaturen bis 900 °C durchgeführt wird.

16. Verfahren nach Anspruch 13, bei dem als Beimengungen Sauerstoff und/oder Stickstoff und/oder Kohlenstoff zugegeben werden.

17. Verfahren nach Anspruch 13, bei dem die Reaktion zu MgB₂-Supraleitern in einer sauerstoffhaltigen oder stickstoffhaltigen oder kohlenstoffhaltigen Atmosphäre realisiert wird.

18. Verfahren nach Anspruch 17, bei dem die Reaktion zu MgB₂-Supraleitern in einer Atmosphäre mit einem Sauerstoffgehalt oder Stickstoffgehalt oder Kohlenstoffgehalt von 0,1 bis 10 Vol.-% durchgeführt wird, wobei die Reaktionstemperatur 900 °C nicht überschreitet.

19. Verfahren nach Anspruch 13, bei dem die Feststoffbeimengungen in der Flüssigphase unter höheren Temperaturen bis über den Schmelzpunkt der Beimengungen zugegeben werden.
